# FASCICULE DE BREVET EUROPEEN

(11) **EP 3 457 223 B1**
(45) Date de publication et mention de la délivrance du brevet: **20.05.2026**
(21) Numéro de dépôt: 17191147.2
(22) Date de dépôt: 14.09.2017
(51) Int. Cl.: G04C 3/04, G04B 17/06, G04B 17/22

(54) **ELEMENT PIEZOELECTRIQUE POUR UN CIRCUIT D'AUTOREGULATION DE FREQUENCE, ET SYSTEME MECANIQUE OSCILLANT ET DISPOSITIF LE COMPRENANT**
PIEZOELEKTRISCHES ELEMENT FÜR EINEN SCHALTKREIS ZUR FREQUENZSELBSTREGULIERUNG, SCHWINGENDES MECHANISCHES SYSTEM UND DIESES UMFASSENDE VORRICHTUNG
PIEZOELECTRIC ELEMENT FOR A FREQUENCY SELF-REGULATION CIRCUIT, AND OSCILLATING MECHANICAL SYSTEM AND DEVICE INCLUDING THE SAME

(43) Date de publication de la demande: 20.03.2019
(73) Titulaire: The Swatch Group Research and Development Ltd, 2074 Marin (CH)
(72) Inventeur: HAEMMERLI, Alexandre, 2000 Neuchâtel (CH); GUEISSAZ François, 2036 Cormondrèche (CH); TOMBEZ, Lionel, 2022 Bevaix (CH); SCHNYDER, Bernhard, 3297 Leuzigen (CH); DALLA PIAZZA, Silvio, 2610 St-Imier (CH)
(74) Mandataire: ICB SA

(56) Documents cités:
- CH-A2- 705 679
- US-B2- 8 721 169

## Description

### DOMAINE TECHNIQUE DE L'INVENTION

L'invention concerne un élément piézoélectrique pour un circuit d'autorégulation de fréquence.

L'invention concerne également un système mécanique oscillant comprenant l'élément piézoélectrique et un balancier.

L'invention concerne en outre un dispositif comprenant le système mécanique oscillant et un circuit d'autorégulation de la fréquence d'oscillation du système mécanique oscillant.

### ETAT DE LA TECHNIQUE

Des éléments piézoélectriques sont communément utilisés dans le domaine des systèmes électromécaniques, par exemple pour la confection d'oscillateurs utilisés comme base de temps, ou encore pour des applications de capteurs de masse, force, gyroscope et bien d'autres.

Dans le domaine de l'horlogerie, et notamment des montres mécaniques ou électromécaniques, il est connu de munir un système mécanique oscillant d'un élément piézoélectrique. Le système mécanique oscillant peut typiquement comprendre un balancier sur lequel est monté un ressort spiral, dont une extrémité est fixée à l'axe de rotation du balancier et l'autre extrémité est fixée sur un élément fixe d'une platine. Le système mécanique est maintenu en oscillation par l'intermédiaire d'une source d'énergie généralement mécanique. Cette source d'énergie peut être par exemple un barillet entraînant un train d'engrenages avec une roue d'échappement coopérant avec une ancre. Cette ancre rotative actionne par exemple une cheville fixée à proximité de l'axe de rotation du balancier. Le balancier avec le ressort spiral peut ainsi former un organe régulateur d'un mouvement d'horlogerie. Cet organe régulateur oscillant détermine la vitesse d'entraînement du train d'engrenages avec la roue d'échappement conduisant aux aiguilles d'indication de l'heure. L'élément piézoélectrique peut comprendre le ressort spiral, sur lequel il est connu de déposer des pellicules d'un matériau piézoélectrique (de type PZT), par exemple sur les faces intérieure et extérieure du ressort. A ce titre, on peut citer les demandes de brevet JP 2002-228774 ou EP 2 590 035 A1. Toutefois, le dépôt de telles pellicules de matériau piézoélectrique sur toute la longueur du ressort spiral introduit une étape supplémentaire coûteuse dans la fabrication du ressort, ce qui est un désavantage.

Dans ces deux demandes de brevet, le réglage de la fréquence d'oscillation du balancier combiné au ressort spiral piézoélectrique est effectué au moyen d'un circuit électronique d'autorégulation de fréquence. Le circuit électronique peut être alimenté directement par la tension alternative générée par l'élément piézoélectrique, qui a été redressée et stockée sur un condensateur. Pour le réglage de la fréquence d'oscillation, il est effectué une comparaison entre un signal à fréquence de référence fourni par un étage oscillateur, et le signal alternatif du générateur. Sur la base de cette comparaison, un signal d'adaptation de fréquence est généré, qui, une fois appliqué à l'élément piézoélectrique, permet d'induire une force de compression ou d'extension sur cet élément pour freiner ou accélérer l'oscillation du système mécanique oscillant.

Un autre exemple d'un dispositif comprenant un système mécanique oscillant muni d'un élément piézoélectrique, et un circuit d'autorégulation de la fréquence d'oscillation du système mécanique oscillant, est fourni par la demande de brevet WO 2011/131784 A1. Selon un exemple de réalisation particulier de ce dispositif, l'élément piézoélectrique comprend un ressort spiral formé d'une bande en matériau piézoélectrique, une première électrode disposée sur une face intérieure du ressort, et une deuxième électrode disposée sur une face extérieure du ressort. Les électrodes sont reliées au circuit d'autorégulation de fréquence. Toutefois, un inconvénient de l'élément piézoélectrique proposé est qu'il ne permet pas d'utiliser l'effet piézoélectrique de l'élément de manière précise et optimale, sans devoir complexifier considérablement la conception du système.

### RESUMÉ DE L'INVENTION

L'invention a donc pour but de fournir un élément piézoélectrique pour un circuit d'autorégulation de fréquence, simple à réaliser et permettant d'utiliser l'effet piézoélectrique de manière précise et optimale, pour pouvoir réguler précisément la fréquence d'oscillation d'un système mécanique oscillant et pour pallier aux inconvénients susmentionnés de l'état de la technique.

A cet effet, l'invention concerne un élément piézoélectrique pour un circuit d'autorégulation de fréquence, qui comprend les caractéristiques mentionnées dans les revendications indépendantes 1 et 2.

Des formes particulières de l'élément piézoélectrique sont définies dans les revendications dépendantes 3 à 13.

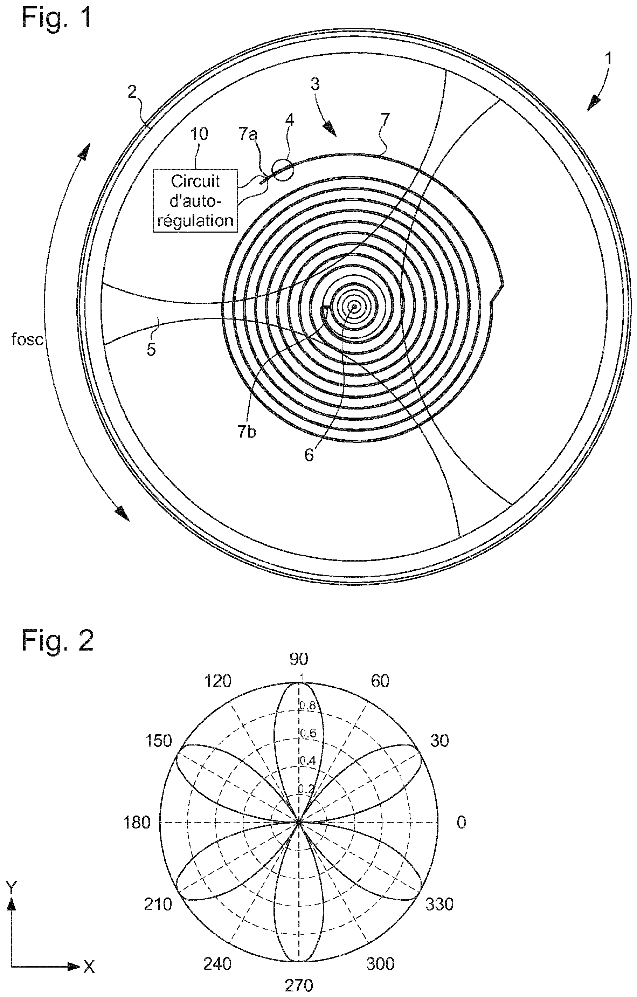

L'utilisation d'un cristal piézoélectrique pour le ressort spiral permet une réalisation simple et économique de l'élément piézoélectrique, tout en conservant de bonnes performances piézoélectriques. En outre, la disposition particulière des première et deuxième électrodes selon une répartition angulaire prédéterminée sur le ressort permet aux électrodes de collecter tout ou partie des charges électriques induites par une contrainte mécanique, en surmontant le problème du changement de polarité des charges dû au changement d'orientation cristalline du cristal piézoélectrique. Ce changement de polarité des charges intervient selon une distribution angulaire périodique au sein du ressort spiral. En effet, la structure cristalline du matériau piézoélectrique induit une dépendance du coefficient piézoélectrique à l'orientation de la contrainte mécanique dans un plan horizontal XY. Autrement dit, suivant la direction de la contrainte dans le plan XY, les charges électriques créées peuvent être positives ou négatives, et leur valeur comprise entre une valeur nulle et une valeur maximale, comme illustré par exemple sur la figure 2 dans le cas du quartz. Grâce à l'élément piézoélectrique selon l'invention, le problème de l'annulation des charges électriques positives et négatives dans chacune des électrodes est surmonté. Sans que cela ne soit limitatif dans le cadre de la présente invention, le cristal piézoélectrique est par exemple un monocristal de quartz.

Selon un premier mode de réalisation de l'invention, les première et deuxième électrodes sont disposées sur une portion d'une spire extérieure du ressort spiral, ladite portion comprenant une extrémité du ressort spiral et définissant un secteur angulaire prédéterminé. Un avantage de ce premier mode de réalisation est la simplicité de fabrication de l'élément piézoélectrique, et en particulier de ses électrodes.

Selon un deuxième mode de réalisation de l'invention, la première électrode comprend des premières parties disposées sur la première face de la bande en matériau piézoélectrique et des secondes parties disposées sur au moins une face de la bande en matériau piézoélectrique distincte de la première face ; et la deuxième électrode comprend des premières parties disposées sur la deuxième face de la bande en matériau piézoélectrique et des secondes parties disposées sur au moins une face de la bande en matériau piézoélectrique distincte de la deuxième face. Les premières et secondes parties de la première électrode, respectivement de la deuxième électrode, sont alternativement reliées entre elles en des zones de jonction. Les zones de jonction sont réparties sur le ressort spiral selon une périodicité angulaire prédéterminée. Un avantage de ce deuxième mode de réalisation est de maximiser la collecte des charges électriques créées, et donc de maximiser la quantité d'énergie électrique recueillie.

Avantageusement, l'élément piézoélectrique comprend une première rainure creusée dans la première face de la bande en matériau piézoélectrique, et une deuxième rainure creusée dans la deuxième face de la bande en matériau piézoélectrique. La première électrode est disposée, au moins partiellement, dans la première rainure, et la deuxième électrode est disposée, au moins partiellement, dans la deuxième rainure. Ceci permet d'augmenter le couplage capacitif entre les électrodes, et d'ainsi augmenter les performances piézoélectriques de l'élément.

A cet effet, l'invention concerne également un système mécanique oscillant comprenant l'élément piézoélectrique pour un circuit d'autorégulation de fréquence, qui comprend les caractéristiques mentionnées dans la revendication 14.

A cet effet, l'invention concerne également un dispositif comprenant le système mécanique oscillant et le circuit d'autorégulation de la fréquence d'oscillation du système mécanique oscillant, qui comprend les caractéristiques mentionnées dans la revendication 15.

Des formes particulières du dispositif sont définies dans les revendications 16 et 17.

### BRÈVE DESCRIPTION DES FIGURES

Les buts, avantages et caractéristiques de l'élément piézoélectrique pour un circuit d'autorégulation de fréquence, et du système mécanique oscillant et du dispositif le comprenant, apparaîtront mieux dans la description suivante sur la base d'au moins une forme d'exécution non limitative illustrée par les dessins sur lesquels :
- la figure 1 représente de manière simplifiée un dispositif, qui comprend un système mécanique oscillant muni d'un élément piézoélectrique selon l'invention, et un circuit d'autorégulation de la fréquence d'oscillation du système mécanique oscillant ;
- la figure 2 est un diagramme d'amplitude de l'effet piézoélectrique de l'élément piézoélectrique selon un exemple de réalisation de l'invention, selon l'orientation d'une contrainte dans un plan XY;
- la figure 3 représente l'élément piézoélectrique selon un premier mode de réalisation de l'invention;
- la figure 4 représente une portion d'une spire extérieure d'un ressort spiral de l'élément piézoélectrique de la figure 3;
- la figure 5 représente une portion d'un ressort spiral de l'élément piézoélectrique selon un deuxième mode de réalisation de l'invention, dans une première variante de réalisation d'électrodes disposées sur le ressort spiral;
- la figure 6 représente une portion d'un ressort spiral de l'élément piézoélectrique selon le deuxième mode de réalisation de l'invention, dans une deuxième variante de réalisation d'électrodes disposées sur le ressort spiral;
- la figure 7 est une vue en coupe de l'élément piézoélectrique de la figure 6, prise selon un plan de coupe VII-VII;
- la figure 8 est une vue en coupe de l'élément piézoélectrique de la figure 6, prise selon un plan de coupe VIII-VIII; et
- la figure 9 représente un schéma bloc simplifié des composants électroniques du circuit d'autorégulation de la figure 1 selon un exemple de réalisation, le circuit étant relié à l'élément piézoélectrique du système mécanique oscillant.

### DESCIRPTION DETAILLEE DE L'INVENTION

Dans la description suivante, il est fait référence à un élément piézoélectrique pour un circuit d'autorégulation de fréquence, notamment un circuit d'autorégulation de la fréquence d'oscillation d'un système mécanique oscillant. Tous les composants électroniques du circuit d'autorégulation de fréquence, qui sont bien connus d'un homme du métier dans ce domaine technique, ne sont décrits que de manière simplifiée. Comme décrit ci-après, le circuit d'autorégulation est principalement utilisé pour réguler la fréquence d'oscillation d'un balancier sur lequel est monté le ressort spiral de l'élément piézoélectrique. Toutefois d'autres systèmes mécaniques oscillants peuvent aussi être envisagés, mais dans la suite de la description il ne sera fait référence qu'à un système mécanique oscillant sous la forme d'un balancier sur lequel est monté le ressort spiral de l'élément piézoélectrique.

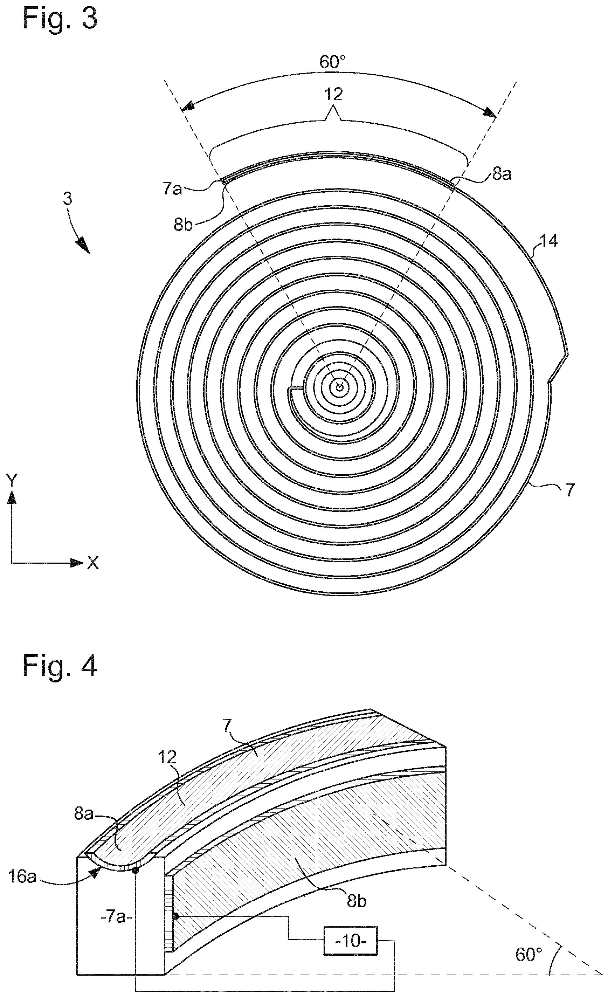

La figure 1 représente un dispositif 1, qui comprend un système mécanique oscillant 2, 3 et un circuit d'autorégulation 10 de la fréquence d'oscillation fosc du système mécanique oscillant. Dans une montre mécanique, le système mécanique oscillant peut comprendre un balancier 2, qui est formé d'un anneau métallique relié par exemple par trois bras 5 à un axe de rotation 6, et un élément piézoélectrique 3, qui comprend un ressort spiral 7. Comme représenté sur les figures 3 à 8, l'élément piézoélectrique 3 comprend en outre au moins deux électrodes 8a-8d reliées électriquement au circuit d'autorégulation de fréquence 10. En revenant à la figure 1, une première extrémité 7a du ressort spiral 7 est maintenue fixe par un piton 4 d'un pont de balancier (non représenté). Ce pont de balancier est fixé à la platine (non représentée) du mouvement de la montre. Une seconde extrémité 7b du ressort spiral 7 est fixée directement sur l'axe de rotation 6 du balancier 2.

Le balancier 2 avec son ressort spiral 7 est maintenu en oscillation par l'intermédiaire d'une source d'énergie (non représentée), qui peut être électrique, mais de préférence mécanique. Cette source d'énergie mécanique peut être un barillet, qui entraîne traditionnellement un train d'engrenages avec une roue d'échappement coopérant avec une ancre. Cette ancre rotative actionne par exemple une cheville fixée à proximité de l'axe de rotation du balancier. Le balancier avec le ressort spiral peut ainsi former un organe régulateur d'un mouvement d'horlogerie.

Le ressort spiral 7 est réalisé au moyen d'une bande en matériau piézoélectrique d'épaisseur généralement inférieure à 0.25 mm, par exemple de l'ordre de 0.1 à 0.2 mm. Le matériau piézoélectrique peut être un cristal piézoélectrique ou une céramique piézoélectrique PZT. De préférence, le cristal piézoélectrique est un monocristal, typiquement du quartz monocristallin dans les exemples de réalisation des figures 2 à 8. Le ressort spiral 7 est par exemple usiné dans du quartz monocristallin de coupe Z, autrement dit de coupe perpendiculaire par rapport à l'axe Z ou axe optique d'un barreau de quartz monocristallin. Un spiral avec des spires espacées l'une de l'autre provenant d'une bande en cristal piézoélectrique est obtenu par un micro-usinage dans un bain d'acide fluorhydrique comme décrit dans la demande de brevet US 2015/0061467 A1, qui est incorporée ici par référence. Au moins deux électrodes métalliques sont déposées sur au moins deux faces de la bande en cristal piézoélectrique selon un agencement qui sera décrit plus en détail par la suite. Plus précisément, les électrodes sont disposées sur une partie ou toute la longueur du ressort spiral 7 selon une répartition angulaire prédéterminée. Chaque électrode est par exemple une électrode du type Au / Cr (Or / Chrome).

La figure 2 représente l'amplitude de l'effet piézoélectrique de l'élément 3 lorsqu'il comprend un ressort spiral 7 en quartz, selon l'orientation d'une contrainte dans un plan horizontal XY. Comme le montre cette figure, la structure cristalline du quartz induit une dépendance du coefficient piézoélectrique à l'orientation de la contrainte mécanique dans le plan XY. Autrement dit, suivant la direction de la contrainte dans le plan XY, les charges électriques créées par le ressort spiral 7 peuvent être positives ou négatives, et leur valeur comprise entre une valeur nulle et une valeur maximale. La structure cristalline du quartz étant trigonale, le maximum des charges électriques se répète tous les 60°, avec un changement de polarité des charges tous les 60° également.

Un premier mode de réalisation de l'invention va maintenant être décrit en référence aux figures 3 et 4. Selon ce premier mode de réalisation, l'élément piézoélectrique 3 comprend deux électrodes 8a, 8b. Les deux électrodes 8a, 8b sont disposées sur une portion 12 d'une spire extérieure 14 du ressort spiral 7. La portion 12 comprend la première extrémité 7a du ressort spiral 7 et définit un secteur angulaire prédéterminé. Dans l'exemple de réalisation préférentiel selon lequel le ressort spiral 7 est formé d'une bande en quartz, le secteur angulaire prédéterminé est sensiblement égal à 60°. Ainsi, et en référence à la figure 2, ce premier mode de réalisation de l'invention permet d'éviter l'annulation mutuelle des charges électriques, due au changement de polarité induit par le changement d'orientation cristalline du ressort spiral 7 en quartz. Les électrodes 8a, 8b collectent une partie des charges électriques induites par une contrainte mécanique, en évitant l'annulation mutuelle des charges.

De préférence, comme illustré sur la figure 4, l'élément piézoélectrique 3 peut comprendre au moins une rainure 16a creusée dans une face supérieure de la bande en cristal piézoélectrique désignée face supérieure. Lors de l'enroulement de la bande en cristal piézoélectrique avec les électrodes 8a, 8b, la face supérieure portant l'électrode 8a est celle perpendiculaire à l'axe de rotation du balancier parallèle au plan du spiral, alors que la face intérieure pour l'électrode 8b est en regard de l'axe de rotation du balancier. La première électrode 8a parmi les deux électrodes est disposée dans la rainure 16a de la face supérieure, et la deuxième électrode 8b est disposée sur la face intérieure.

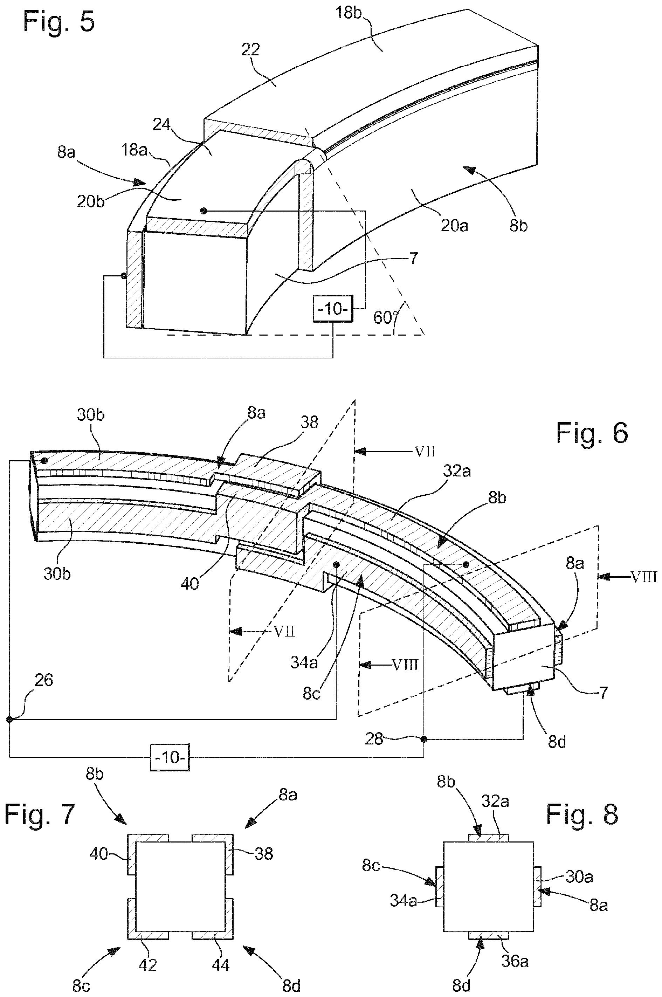

Les figures 5 à 8 illustrent un deuxième mode de réalisation de l'invention pour lequel les éléments analogues au premier mode de réalisation, décrit précédemment, sont repérés par des références identiques, et ne sont donc pas décrits à nouveau.

Selon une première variante de réalisation représentée à la figure 5, une première électrode 8a parmi les deux électrodes comprend des premières parties 18a disposées sur la face extérieure de la bande en cristal piézoélectrique, et des secondes parties 18b disposées sur une face de la bande désignée face supérieure. Une deuxième électrode 8b comprend des premières parties 20a disposées sur la face intérieure de la bande en cristal piézoélectrique, et des secondes parties 20b disposées sur la face supérieure. De préférence, les deux électrodes 8a, 8b s'étendent sur toute la longueur du ressort spiral 7, bien que seule une portion de ce dernier, et donc seules une première partie 18a, 20a et une seconde partie 18b, 20b de chaque électrode 8a, 8b, soient représentées à la figure 5.

Les premières parties 18a et les secondes parties 18b de la première électrode 8a sont alternativement reliées entre elles en des premières zones de jonction 22. Les premières parties 20a et les secondes parties 20b de la deuxième électrode 8b sont alternativement reliées entre elles en des secondes zones de jonction 24, adjacentes aux premières zones de jonction 22. Les premières et secondes zones de jonction 22, 24 sont réparties sur le ressort spiral 7 selon une périodicité angulaire prédéterminée. Les secondes parties 18b, 20b des première et deuxième électrodes 8a, 8b s'étendent successivement et alternativement l'une de l'autre sur la face supérieure de la bande en cristal piézoélectrique, selon cette même périodicité angulaire prédéterminée. En variante non représentée, les secondes parties 18b, 20b des première et deuxième électrodes 8a, 8b pourraient s'étendre de la même manière sur une face de la bande en cristal piézoélectrique désignée face inférieure. Dans l'exemple de réalisation préférentiel selon lequel le ressort spiral 7 est formé d'une bande en quartz, la périodicité angulaire prédéterminée est sensiblement égale à 60°.

Selon une deuxième variante de réalisation représentée aux figures 6 à 8, outre les première et deuxième électrodes 8a, 8b, l'élément piézoélectrique 3 comprend également une troisième et une quatrième électrodes 8c, 8d. Comme illustré sur la figure 6, la troisième électrode 8c, qui est de la même polarité que la première électrode 8a, est connectée à celle-ci en une première borne de connexion 26. La quatrième électrode 8d, qui est de même polarité que la deuxième électrode 8b, est connectée à celle-ci en une deuxième borne de connexion 28. Les première et deuxième bornes de connexion 26, 28 sont chacune reliées au circuit d'autorégulation de fréquence 10. Dans un exemple de réalisation particulier, non représenté sur les figures, les première et deuxième bornes de connexion 26, 28 sont disposées sur le piton 4 maintenant fixe la première extrémité 7a du ressort spiral 7.

La première électrode 8a comprend des premières parties 30a disposées sur la face extérieure de la bande en cristal piézoélectrique, et des secondes parties 30b disposées sur chaque face de la bande distincte de la face extérieure. La deuxième électrode 8b comprend des premières parties 32a disposées sur la face supérieure de la bande en cristal piézoélectrique, et des secondes parties 32b disposées sur chaque face de la bande distincte de la face supérieure. La troisième électrode 8c comprend des premières parties 34a disposées sur la face intérieure de la bande en cristal piézoélectrique, et des secondes parties disposées sur chaque face de la bande distincte de la face intérieure. La quatrième électrode 8d comprend des premières parties 36a disposées sur la face inférieure de la bande en cristal piézoélectrique, et des secondes parties disposées sur chaque face de la bande distincte de la face inférieure. De préférence, les quatre électrodes 8a, 8b, 8c, 8d s'étendent sur toute la longueur du ressort spiral 7, bien que seule une portion de ce dernier soit représentée sur la figure 6. Les secondes parties des troisième et quatrième électrodes 8c, 8d ne sont ainsi pas visibles sur les figures 6 à 8.

Les premières parties 30a et les secondes parties 30b de la première électrode 8a sont alternativement reliées entre elles en des premières zones de jonction 38. Les premières parties 32a et les secondes parties 32b de la deuxième électrode 8b sont alternativement reliées entre elles en des deuxièmes zones de jonction 40. Les premières parties 34a et les secondes parties de la troisième électrode 8c sont alternativement reliées entre elles en des troisièmes zones de jonction 42. Les premières parties 36a et les secondes parties de la quatrième électrode 8d sont alternativement reliées entre elles en des quatrièmes zones de jonction 44. Les différentes zones de jonction 38 - 44 sont réparties sur le ressort spiral 7 selon une périodicité angulaire prédéterminée.

Comme illustré sur la figure 7, chaque zone de jonction 38 - 44 s'étend à cheval sur deux faces adjacentes de la bande en cristal piézoélectrique. Ainsi, les première, deuxième, troisième et quatrième électrodes 8a, 8b, 8c, 8d s'étendent successivement et alternativement les unes des autres sur chaque face de la bande en cristal piézoélectrique, selon une sous-périodicité angulaire prédéterminée. Dans l'exemple de réalisation préférentiel selon lequel le ressort spiral 7 est formé d'une bande en quartz, la sous-périodicité angulaire prédéterminée est sensiblement égale à 60°.

En référence à la figure 2, ce deuxième mode de réalisation de l'invention permet d'éviter l'annulation mutuelle des charges électriques, due au changement de polarité induit par le changement d'orientation cristalline du ressort spiral 7 en quartz. Via un changement périodique de faces des électrodes, celles-ci collectent la totalité des charges électriques induites par une contrainte mécanique, en évitant l'annulation mutuelle des charges. Dans le cadre du dispositif 1 comprenant le système mécanique oscillant 2, 3, la totalité des charges électriques créées par le système oscillant 2, 3 est recueillie, permettant ainsi de maximiser la quantité d'énergie électrique recueillie et fournie au circuit 10.

Bien que non représentées sur les figures 5 à 8, l'élément piézoélectrique 3 selon ce deuxième mode de réalisation peut avantageusement comprendre des rainures de support d'électrodes, creusées dans des faces opposées de la bande en cristal piézoélectrique, qui sont les faces supérieure et inférieure.

Lors de l'oscillation du balancier 2 avec le ressort spiral 7, une force de compression ou une force d'extension est appliquée alternativement à la bande en cristal piézoélectrique, qui ensemble génèrent ainsi une tension alternative. La fréquence d'oscillation du balancier 2 avec le ressort spiral 7 peut être située typiquement entre 3 et 10 Hz. Le circuit d'autorégulation 10 reçoit donc cette tension alternative, via les électrodes auxquelles il est relié. Le circuit d'autorégulation peut être relié directement ou par l'intermédiaire de deux fils métalliques aux électrodes.

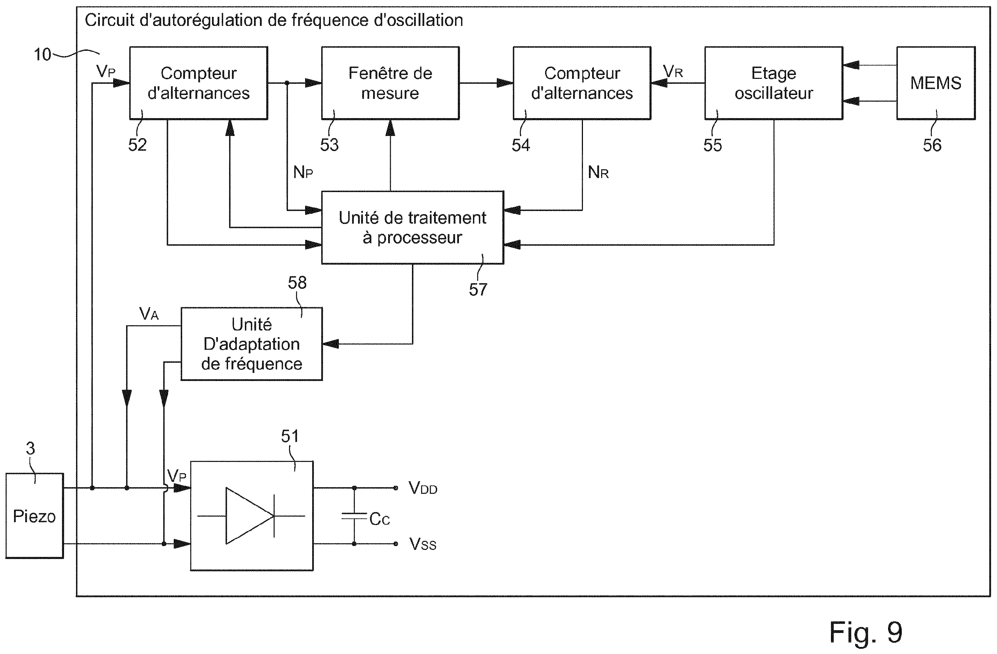

La figure 9 représente les différents éléments électroniques d'un exemple de réalisation du circuit d'autorégulation 10 permettant de réguler la fréquence d'oscillation du système mécanique oscillant. D'autres exemples de circuits d'autorégulation de fréquence peuvent indifféremment être envisagés sans sortir du cadre de l'invention.

Le circuit d'autorégulation 10 est relié à deux électrodes ou groupes d'électrodes de l'élément piézoélectrique 3. Le circuit d'autorégulation 10 est en mesure de redresser la tension alternative VP reçue de l'élément piézoélectrique 3 par l'intermédiaire d'un redresseur 51 traditionnel. La tension redressée de la tension alternative VP est stockée sur un condensateur Cc. Cette tension redressée entre les bornes VDD et VSS du condensateur Cc peut être suffisante pour alimenter tous les éléments électroniques du circuit d'autorégulation sans l'aide d'une source de tension supplémentaire comme une batterie ou un élément de conversion d'énergie, telle qu'une cellule solaire, un générateur thermoélectrique ou autre.

Le circuit d'autorégulation 10 comprend un étage oscillateur 55, connecté par exemple à un résonateur du type MEMS 56. Le circuit oscillant de l'étage oscillateur avec le résonateur MEMS fournit un signal oscillant, qui peut être d'une fréquence inférieure à 500 kHz, par exemple de l'ordre de 200 kHz. Ainsi l'étage oscillateur 55 peut fournir de préférence un signal de référence VR, dont la fréquence peut être égale à la fréquence du signal oscillant du circuit oscillateur.

Pour pouvoir réguler la fréquence d'oscillation du système mécanique oscillant, une comparaison doit être effectuée dans le circuit d'autorégulation 10 entre la tension alternative VP et le signal de référence VR. Pour ce faire, le circuit d'autorégulation 10 comprend des moyens de comparaison 52, 53, 54, 57 pour comparer la fréquence de la tension alternative VP avec la fréquence du signal de référence VR. Dans le cas où la fréquence du signal de référence correspond à la fréquence du circuit oscillant de l'étage oscillateur 55, c'est-à-dire à une fréquence de l'ordre de 200 kHz, les moyens de comparaison doivent être conçus de telle manière à tenir compte de l'écart important de fréquence entre la tension alternative VP et le signal de référence VR.

Les moyens de comparaison sont constitués tout d'abord d'un premier compteur d'alternances 52, qui reçoit en entrée la tension alternative VP de l'élément piézoélectrique, et qui fournit un premier signal de comptage NP à une unité de traitement à processeur 57. Les moyens de comparaison comprennent encore un second compteur d'alternances 54, qui reçoit en entrée le signal de référence VR, et qui fournit un second signal de comptage NR à l'unité de traitement à processeur 57.

Pour tenir compte de l'écart de fréquence entre la tension alternative VP et le signal de référence VR, il est prévu encore une fenêtre de mesure 53 disposée entre le premier compteur d'alternances 52 et le second compteur d'alternances 54. Cette fenêtre de mesure 53 détermine le temps de comptage du second compteur d'alternances 54. L'unité de traitement à processeur 57 fournit des paramètres de configuration à la fenêtre de mesure 53 pour déterminer le temps de comptage pour le second compteur d'alternances. Ces paramètres de configuration sont mémorisés dans une mémoire non représentée dans l'unité de traitement à processeur. Ces paramètres de configuration peuvent être différents selon qu'il s'agisse d'une montre pour dame ou d'une montre pour homme. Les différentes opérations traitées dans l'unité de traitement à processeur 57 peuvent être contrôlées par un signal d'horloge fourni par exemple par le circuit oscillant de l'étage oscillateur 55.

Le temps de comptage du second compteur d'alternances 54 est adapté proportionnellement au temps de comptage d'un certain nombre déterminé d'alternances comptées par le premier compteur d'alternances 52 dans le premier signal de comptage NP. L'unité de traitement à processeur 57 peut éventuellement commander aussi le premier compteur d'alternances 52 pour définir le début et la fin d'une période de comptage. Cependant il peut aussi être envisagé que le premier compteur d'alternances 52 fournisse une information du début et de la fin d'un nombre déterminé d'alternances comptées à l'unité de traitement à processeur 57. S'il est prévu de compter par exemple 200 alternances dans le premier compteur d'alternances, la fenêtre de mesure 53 est configurée pour que le second compteur d'alternances 54 compte un nombre d'alternances du signal de référence VR pendant une durée à peu près 5000 fois inférieure. Cette durée peut être dépendante aussi du temps de comptage par exemple des 200 alternances du premier compteur d'alternances 52. Cela permet de réduire la consommation électrique du circuit d'autorégulation.

Le début de comptage commandé par la fenêtre de mesure 53 peut être déterminé par le premier compteur d'alternances 52, mais peut aussi de préférence être commandé directement par l'unité de traitement à processeur 57. L'unité de traitement à processeur 57 peut recevoir tout d'abord le premier signal de comptage NP relatif à un premier nombre déterminé d'alternances comptées de la tension alternative VP dans un premier intervalle de temps. Ce premier signal de comptage est mémorisé par exemple dans un registre de l'unité de traitement à processeur. Par la suite, l'unité de traitement à processeur 57 peut recevoir le second signal de comptage NR relatif à un second nombre d'alternances comptées dans le second compteur d'alternances 54 dans un second intervalle de temps commandé par la fenêtre de mesure 53. Ce second signal de comptage NR peut aussi être mémorisé dans un autre registre de l'unité de traitement à processeur. Finalement une comparaison des deux signaux de comptage est effectuée dans l'unité de traitement à processeur 57 pour déterminer si la fréquence de la tension alternative VP est trop élevée ou trop basse par rapport proportionnellement à la fréquence du signal de référence.

Sur la base de la comparaison effectuée entre les deux signaux de comptage NP et NR dans l'unité de traitement à processeur, ladite unité de traitement à processeur commande une unité d'adaptation de fréquence 58, dont la sortie est reliée aux deux électrodes ou groupes d'électrodes de l'élément piézoélectrique 3. Cette unité d'adaptation de fréquence 58 peut être prévue pour fournir un signal d'adaptation de fréquence, qui est une tension continue VA, dont le niveau est fonction de la différence entre les deux signaux de comptage communiquée par l'unité de traitement à processeur. Un réseau commutable de condensateurs ou de résistances peut être prévu à cet effet. Il peut être fourni une valeur de tension continue par l'intermédiaire d'un suiveur de tension de l'unité d'adaptation 58 à une des électrodes ou groupes d'électrodes de l'élément piézoélectrique 3 ou à l'autre électrode ou groupe d'électrodes de l'élément piézoélectrique. Cela permet ainsi d'induire une certaine force sur l'élément piézoélectrique pour freiner ou accélérer l'oscillation du système mécanique oscillant en fonction de la comparaison des deux signaux de comptage.

Le circuit d'autorégulation 10 peut comprendre également des éléments de compensation thermique bien connus, ainsi qu'une unité de remise à zéro à chaque enclenchement du circuit d'autorégulation 10. Tous les composants électroniques du circuit d'autorégulation, ainsi que le résonateur MEMS 56 et le condensateur Cc font par exemple partie d'un même module électronique compact. Tous ces composants électroniques peuvent être intégrés avantageusement dans un même substrat silicium monolithique, ce qui permet de n'avoir qu'un seul module électronique autoalimenté pour la régulation de fréquence du système mécanique oscillant.

La description précédente de l'élément piézoélectrique selon l'invention a été faite en référence à un ressort spiral formé d'une bande en quartz monocristallin. Toutefois, le quartz utilisé en tant que cristal piézoélectrique n'est nullement limitatif dans le cadre de la présente invention, et d'autres cristaux piézoélectriques peuvent aussi être envisagés pour former le ressort spiral, tels que par exemple, sans que cette liste ne soit exhaustive, la topaze, la berlinite, le niobate de lithium, le tantalate de lithium, le phosphate de gallium, l'arséniate de gallium, le silicate d'aluminium, le dioxyde de germanium, un monocristal du groupe des tourmalines, un monocristal du groupe des semi-conducteurs III-V de structure zinc-blende ou encore un monocristal du groupe des semi-conducteurs II-VI de structure wurtzite.

Par conséquent, bien que la description de l'invention donnée ci-avant a été faite en référence à un changement de polarité des charges respectant une distribution angulaire périodique de 60°, due à la structure cristalline du quartz ; d'autres distributions angulaires périodiques peuvent également être envisagées sans sortir du cadre de l'invention définie par les revendications, selon les différents types de cristaux piézoélectriques utilisés pour former le ressort spiral.

Les deux modes de réalisation de l'élément piézoélectrique selon l'invention, décrits ci-dessus dans le cadre d'une régulation de la fréquence d'oscillation du système mécanique oscillant, peuvent également être utilisés avantageusement pour mesurer cette fréquence d'oscillation, et/ou pour effectuer des corrections de phase du système et/ou pour collecter de l'énergie.

## Revendications

1. Elément piézoélectrique (3) pour un circuit d'autorégulation de fréquence (10), l'élément piézoélectrique (3) comprenant :
- un ressort spiral (7) formé d'une bande en matériau piézoélectrique;
- une première électrode (8a), destinée à être reliée au circuit d'autorégulation de fréquence (10), et disposée sur au moins une première face de la bande en matériau piézoélectrique;
- une deuxième électrode (8b), destinée à être reliée au circuit d'autorégulation de fréquence (10), et disposée sur au moins une deuxième face de la bande en matériau piézoélectrique;
**caractérisé en ce que** le matériau piézoélectrique est un cristal piézoélectrique ou une céramique piézoélectrique, et
**en ce que** les première et deuxième électrodes (8a, 8b) sont disposées sur une portion d'une spire extérieure du ressort spiral (7), ladite portion comprenant une extrémité du ressort spiral et définissant un secteur angulaire prédéterminé.

2. Elément piézoélectrique (3) pour un circuit d'autorégulation de fréquence (10), l'élément piézoélectrique (3) comprenant :
- un ressort spiral (7) formé d'une bande en matériau piézoélectrique;
- une première électrode (8a), destinée à être reliée au circuit d'autorégulation de fréquence (10), et disposée sur au moins une première face de la bande en matériau piézoélectrique;
- une deuxième électrode (8b), destinée à être reliée au circuit d'autorégulation de fréquence (10), et disposée sur au moins une deuxième face de la bande en matériau piézoélectrique;
**caractérisé en ce que** le matériau piézoélectrique est un cristal piézoélectrique ou une céramique piézoélectrique,
**en ce que** la première électrode (8a) comprend des premières parties disposées sur la première face de la bande en matériau piézoélectrique, et des secondes parties disposées sur au moins une face de la bande en matériau piézoélectrique distincte de la première face,
**en ce que** la deuxième électrode (8b) comprend des premières parties disposées sur la deuxième face de la bande en matériau piézoélectrique, et des secondes parties disposées sur au moins une face de la bande en matériau piézoélectrique distincte de la deuxième face,
**en ce que** les premières et secondes parties de la première électrode (8a), respectivement de la deuxième électrode (8b), sont alternativement reliées entre elles en des zones de jonction, et
**en ce que** les zones de jonction sont réparties sur le ressort spiral (7) selon une périodicité angulaire prédéterminée.

3. Elément piézoélectrique (3) selon la revendication 1, **caractérisé en ce que** les première et deuxième électrodes (8a, 8b) sont disposées sur une portion (12) d'une spire extérieure (14) du ressort spiral (7), ladite portion (12) comprenant une extrémité (7a) du ressort spiral (7) et définissant un secteur angulaire prédéterminé.

4. Elément piézoélectrique (3) selon la revendication 1, **caractérisé en ce que** la première électrode (8a) comprend des premières parties (18a ; 30a) disposées sur la première face de la bande en matériau piézoélectrique et des secondes parties (18b ; 30b) disposées sur au moins une face de la bande en matériau piézoélectrique distincte de la première face ; **en ce que** la deuxième électrode (8b) comprend des premières parties (20a ; 32a) disposées sur la deuxième face de la bande en matériau piézoélectrique et des secondes parties (20b ; 32b) disposées sur au moins une face de la bande en matériau piézoélectrique distincte de la deuxième face ; les premières et secondes parties de la première électrode (8a), respectivement de la deuxième électrode (8b), étant alternativement reliées entre elles en des zones de jonction (22, 24 ; 38, 40) ; et **en ce que** lesdites zones de jonction (22, 24 ; 38, 40) sont réparties sur le ressort spiral (7) selon une périodicité angulaire prédéterminée.

5. Elément piézoélectrique (3) selon la revendication 4, **caractérisé en ce que** les secondes parties (18b) de la première électrode (8a) et les secondes parties (20b) de la deuxième électrode (8b) sont disposées sur une troisième face de la bande en matériau piézoélectrique ; et **en ce que** lesdites secondes parties (18b, 20b) des première et deuxième électrodes (8a, 8b) s'étendent successivement et alternativement l'une de l'autre sur la troisième face de la bande en matériau piézoélectrique selon ladite périodicité angulaire prédéterminée.

6. Elément piézoélectrique selon la revendication 4, **caractérisé en ce qu'**il comprend une troisième électrode (8c) et une quatrième électrode (8d) ; la troisième électrode (8c) étant connectée à la première électrode (8a) en une première borne de connexion (26) destinée à être reliée au circuit d'autorégulation de fréquence (10), la troisième électrode (8c) comprenant des premières parties (34a) disposées sur une troisième face de la bande en matériau piézoélectrique et des secondes parties disposées sur au moins une face de la bande en matériau piézoélectrique distincte de la troisième face ; la quatrième électrode (8d) étant connectée à la deuxième électrode (8b) en une deuxième borne de connexion (28) destinée à être reliée au circuit d'autorégulation de fréquence (10), la quatrième électrode (8d) comprenant des premières parties (36a) disposé4es sur une quatrième face de la bande en matériau piézoélectrique et des secondes parties disposées sur au moins une face de la bande en matériau piézoélectrique distincte de la quatrième face ; les premières et secondes parties de la troisième électrode (8c), respectivement de la quatrième électrode (8d), étant alternativement reliées entre elles en des zones de jonction (42, 44) ; et **en ce que** lesdites zones de jonction (42, 44) sont réparties sur le ressort spiral (7) selon ladite périodicité angulaire prédéterminée.

7. Elément piézoélectrique (3) selon la revendication 6, **caractérisé en ce que** chaque seconde partie de la première, deuxième, troisième, respectivement quatrième électrode s'étend sur chaque face de la bande en matériau piézoélectrique distincte de la première, deuxième, troisième, respectivement quatrième face ; et **en ce que** les première, deuxième, troisième et quatrième électrodes (8a-8d) s'étendent successivement et alternativement les unes des autres sur chaque face de la bande en matériau piézoélectrique, selon une sous-périodicité angulaire prédéterminée.

8. Elément piézoélectrique (3) selon l'une des revendications 5 à 7, **caractérisé en ce que** les électrodes sont disposées sur toute la longueur du ressort spiral.

9. Elément piézoélectrique (3) selon la revendication 1, **caractérisé en ce que** le cristal piézoélectrique est un monocristal choisi parmi le groupe consistant en la topaze, la berlinite, le niobate de lithium, le tantalate de lithium, le phosphate de gallium, l'arséniate de gallium, le silicate d'aluminium, le dioxyde de germanium, un monocristal du groupe des tourmalines, un monocristal du groupe des semi-conducteurs III-V de structure zinc-blende et un monocristal du groupe des semi-conducteurs II-VI de structure wurtzite.

10. Elément piézoélectrique (3) selon la revendication 1, **caractérisé en ce que** le cristal piézoélectrique est du quartz monocristallin.

11. Elément piézoélectrique (3) selon la revendication 10, **caractérisé en ce que** le ressort spiral (7) est usiné dans du quartz monocristallin de coupe Z.

12. Elément piézoélectrique (3) selon la revendication 9 ou 10 lorsqu'elle dépend de la revendication 2 ou 3, **caractérisé en ce que** le secteur angulaire prédéterminé, la périodicité angulaire prédéterminée ou la sous-périodicité angulaire prédéterminée est sensiblement égal(e) à 60°.

13. Elément piézoélectrique (3) selon l'une quelconque des revendications précédentes, **caractérisé en ce qu'**il comprend en outre au moins une rainure (16a) creusée dans la première face supérieure ou inférieure de la bande en matériau piézoélectrique, ladite première électrode (8a) étant disposée, au moins partiellement, dans ladite rainure (16a), ladite deuxième électrode (8b) étant disposée, au moins partiellement, sur une deuxième face extérieure ou intérieure.

14. Système mécanique oscillant pour un circuit d'autorégulation de fréquence (10), comprenant un balancier (2) et un élément piézoélectrique (3) muni d'un ressort spiral (7), le ressort spiral (7) étant monté sur ledit balancier (2), **caractérisé en ce que** l'élément piézoélectrique (3) est conforme à l'une quelconque des revendications précédentes.

15. Dispositif (1) comprenant le système mécanique oscillant selon la revendication 14 et un circuit (10) d'autorégulation de la fréquence d'oscillation du système mécanique oscillant, ledit circuit d'autorégulation (10) comprenant un étage oscillateur (55) apte à fournir un signal de référence (V_{R}), des moyens (52, 53, 54, 57) de comparaison de fréquence entre deux signaux, et une unité d'adaptation de fréquence (58) reliée à l'élément piézoélectrique (3) du système mécanique oscillant et apte à fournir un signal d'adaptation de fréquence (V_{A}), **caractérisé en ce que** l'élément piézoélectrique (3) du système mécanique oscillant est apte à générer une tension alternative (V_{P}) à fréquence correspondant au système mécanique oscillant, les première et deuxième électrodes (8a, 8b) de l'élément piézoélectrique étant reliées au circuit d'autorégulation (10) de manière à recevoir de l'unité d'adaptation de fréquence (58) le signal d'adaptation de fréquence (V_{A}), sur la base du résultat d'une comparaison de fréquence, dans les moyens de comparaison de fréquence, entre la tension alternative (V_{P}) et le signal de référence (V_{R}).

16. Dispositif (1) selon la revendication 15, **caractérisé en ce que** le circuit (10) d'autorégulation de la fréquence d'oscillation du système mécanique oscillant comprend en outre un redresseur (51) pour redresser la tension alternative (V_{P}) générée par l'élément piézoélectrique (3) et pour stocker la tension redressée sur au moins un condensateur (Cc) pour pouvoir alimenter en électricité le circuit d'autorégulation.

17. Dispositif (1) selon la revendication 15 ou 16, **caractérisé en ce que** l'étage oscillateur (55) du circuit d'autorégulation (10) comprend un circuit oscillant relié à un résonateur MEMS (56) pour fournir un signal oscillant, afin que l'étage oscillateur (55) fournisse le signal de référence (V_{R}), tous les composants électroniques du circuit d'autorégulation étant regroupés pour ne former qu'un unique module électronique.

## Patentansprüche

1. Piezoelektrisches Element (3) für einen Schaltkreis zur Frequenzselbstregulierung (10), das piezoelektrische Element (3) umfassend:
- eine Unruhspirale (7), die aus einem piezoelektrischen Bandmaterial gebildet ist;
- eine erste Elektrode (8a), die mit dem Schaltkreis zur Frequenzselbstregulierung (10) verbunden ist und auf mindestens einer ersten Seite des piezoelektrischen Bandmaterials angebracht ist;
- eine zweite Elektrode (8b), die mit dem Schaltkreis zur Frequenzselbstregulierung (10) verbunden ist und auf mindestens einer zweiten Seite des piezoelektrischen Bandmaterials angebracht ist;
**dadurch gekennzeichnet, dass** das piezoelektrische Material ein Piezokristall oder eine piezoelektrische Keramik ist; und
dadurch, dass die erste und zweite Elektrode (8a, 8b) auf einem Abschnitt einer äußeren Windung der Unruhspirale (7) angebracht sind, wobei der Abschnitt ein Ende der Unruhspirale umfasst und einen vorbestimmten Winkelsektor definiert.

2. Piezoelektrisches Element (3) für einen Schaltkreis zur Frequenzselbstregulierung (10), das piezoelektrische Element (3) umfassend:
- eine Unruhspirale (7), die aus einem piezoelektrischen Bandmaterial gebildet ist;
- eine erste Elektrode (8a), die mit dem Schaltkreis zur Frequenzselbstregulierung (10) verbunden ist und auf mindestens einer ersten Seite des piezoelektrischen Bandmaterials angebracht ist;
- eine zweite Elektrode (8b), die mit dem Schaltkreis zur Frequenzselbstregulierung (10) verbunden ist und auf mindestens einer zweiten Seite des piezoelektrischen Bandmaterials angebracht ist;
**dadurch gekennzeichnet, dass** das piezoelektrische Material ein Piezokristall oder eine piezoelektrische Keramik ist,
dadurch, dass die erste Elektrode (8a) erste Teile umfasst, die auf der ersten Seite des piezoelektrischen Bandmaterials angebracht sind, und zweite Teile, die auf mindestens einer Seite des piezoelektrischen Bandmaterials, die sich von der ersten Seite unterscheidet, angebracht sind,
dadurch, dass die zweite Elektrode (8b) erste Teile umfasst, die auf der zweiten Seite des piezoelektrischen Bandmaterials angebracht sind, und zweite Teile, die auf mindestens einer Seite des piezoelektrischen Bandmaterials, die sich von der zweiten Seite unterscheidet, angebracht sind,
dadurch, dass die ersten und zweiten Teile der ersten Elektrode (8a) bzw. der zweiten Elektrode (8b) in Verbindungsbereichen abwechselnd miteinander verbunden sind, und
dadurch, dass die Verbindungsbereiche mit einer vorbestimmten Winkelfrequenz über die Unruhspirale (7) verteilt sind.

3. Piezoelektrisches Element (3) nach Anspruch 1, **dadurch gekennzeichnet, dass** die erste und zweite Elektrode (8a, 8b) auf einem Abschnitt (12) einer äußeren Windung (14) der Unruhspirale (7) angebracht sind, wobei der Abschnitt (12) ein Ende (7a) der Unruhspirale (7) umfasst und einen vorbestimmten Winkelsektor definiert.

4. Piezoelektrisches Element (3) nach Anspruch 1, **dadurch gekennzeichnet, dass** die erste Elektrode (8a) erste Teile (18a; 30a) umfasst, die auf der ersten Seite des piezoelektrischen Bandmaterials angebracht sind, und zweite Teile (18b; 30b), die auf mindestens einer Seite des piezoelektrischen Bandmaterials, die sich von der ersten Seite unterscheidet, angebracht sind; dass die zweite Elektrode (8b) erste Teile (20a; 32a) umfasst, die auf der zweiten Seite des piezoelektrischen Bandmaterials angebracht sind, und zweite Teile (20b; 32b), die auf mindestens einer Seite des piezoelektrischen Bandmaterials, die sich von der zweiten Seite unterscheidet, angebracht sind; wobei die ersten und zweiten Teile der ersten Elektrode (8a) bzw. der zweiten Elektrode (8b) in Verbindungsbereichen (22, 24; 38, 40) abwechselnd miteinander verbunden sind; und dass die Verbindungsbereiche (22, 24; 38, 40) mit einer vorbestimmten Winkelperiodizität über die Unruhspirale (7) verteilt sind.

5. Piezoelektrisches Element (3) nach Anspruch 4, **dadurch gekennzeichnet, dass** die zweiten Teile (18b) der ersten Elektrode (8a) und die zweiten Teile (20b) der zweiten Elektrode (8b) auf einer dritten Seite des piezoelektrischen Bandmaterials angebracht sind; und dass die zweiten Teile (18b, 20b) der ersten und zweiten Elektrode (8a, 8b) sich mit der vorbestimmten Winkelperiodizität nacheinander und abwechselnd aufeinanderfolgend auf der dritten Seite des piezoelektrischen Bandmaterials erstrecken.

6. Piezoelektrisches Element nach Anspruch 4, **dadurch gekennzeichnet, dass** es eine dritte Elektrode (8c) und eine vierte Elektrode (8d) umfasst; wobei die dritte Elektrode (8c) mit der ersten Elektrode (8a) an einem ersten Verbindungsanschluss (26) verbunden ist, um mit dem Schaltkreis zur Frequenzselbstregulierung (10) verbunden zu sein, wobei die dritte Elektrode (8c) erste Teile (34a) umfasst, die auf einer dritten Seite des piezoelektrischen Bandmaterials angebracht sind, und zweite Teile, die auf mindestens einer Seite des piezoelektrischen Bandmaterials, die sich von der dritten Seite unterscheidet, angebracht sind; wobei die vierte Elektrode (8d) mit der zweiten Elektrode (8b) an einem zweiten Verbindungsanschluss (28) verbunden ist, um mit dem Schaltkreis zur Frequenzselbstregulierung (10) verbunden zu sein, wobei die vierte Elektrode (8d) erste Teile (36a) umfasst, die auf einer vierten Seite des piezoelektrischen Bandmaterials angebracht sind, und zweite Teile, die auf mindestens einer Seite des piezoelektrischen Bandmaterials, die sich von der vierten Seite unterscheidet, angebracht sind; wobei die ersten und zweiten Teile der dritten Elektrode (8c) bzw. der vierten Elektrode (8d) in Verbindungsbereichen (42, 44) abwechselnd miteinander verbunden sind; und dass die Verbindungsbereiche (42, 44) mit einer vorbestimmten Winkelperiodizität über die Unruhspirale (7) verteilt sind.

7. Piezoelektrisches Element (3) nach Anspruch 6, **dadurch gekennzeichnet, dass** sich jeder zweite Teil der ersten, zweiten, dritten bzw. vierten Elektrode über jede Seite des piezoelektrischen Bandmaterials, die sich von der ersten, zweiten, dritten bzw. vierten Seite unterscheidet, erstreckt; und dass sich die erste, zweite, dritte und vierte Elektrode (8a-8d) mit einer vorbestimmten Winkel-Subperiodizität nacheinander und abwechselnd aufeinanderfolgend auf jeder Seite des piezoelektrischen Bandmaterials erstrecken.

8. Piezoelektrisches Element (3) nach den Ansprüchen 5 bis 7, **dadurch gekennzeichnet, dass** die Elektroden über die gesamte Länge der Unruhspirale angebracht sind.

9. Piezoelektrisches Element (3) nach Anspruch 1, **dadurch gekennzeichnet, dass** der Piezokristall ein Einkristall ist, der aus der Gruppe ausgewählt ist, die aus Topas, Berlinit, Lithiumniobat, Lithiumtantalat, Galliumphosphat, Galliumarsenat, Aluminiumsilikat, Germaniumdioxid, einem Turmalin-Einkristall, einem Einkristall aus der Gruppe von III-V-Halbleiter in Zinkblende-Struktur, oder einem Einkristall aus der Gruppe von II-VI-Halbleiter in Wurtzit-Struktur besteht.

10. Piezoelektrisches Element (3) nach Anspruch 1, **dadurch gekennzeichnet, dass** der Piezokristall einkristalliner Quarz ist.

11. Piezoelektrisches Element (3) nach Anspruch 10, **dadurch gekennzeichnet, dass** die Unruhspirale (7) aus Z-geschnittenem einkristallinem Quarz gefertigt ist.

12. Piezoelektrisches Element (3) nach Anspruch 9 oder 10, wenn es von Anspruch 2 oder 3 abhängt, **dadurch gekennzeichnet, dass** der vorbestimmte Winkelsektor, die vorbestimmte Winkelperiodizität oder die vorbestimmte Winkel-Subperiodizität im Wesentlichen gleich 60° ist.

13. Piezoelektrisches Element (3) nach einem der vorhergehenden Ansprüche, **dadurch gekennzeichnet, dass** es ferner mindestens eine Nut (16a) umfasst, die in die erste obere oder untere Seite des piezoelektrischen Bandmaterials eingeschnitten ist, wobei die erste Elektrode (8a) mindestens teilweise in die Nut (16a) eingepasst ist, wobei die zweite Elektrode (8b) mindestens teilweise auf einer zweiten äußeren oder inneren Seite angebracht ist.

14. Schwingungsfähiges mechanisches System für einen Schaltkreis zur Frequenzselbstregulierung (10), umfassend eine Unruh (2) und ein piezoelektrisches Element (3), das mit einer Unruhspirale (7) bereitgestellt ist, wobei die Unruhspirale (7) auf der Unruh (2) montiert ist, **dadurch gekennzeichnet, dass** das piezoelektrische Element (3) einem der vorhergehenden Ansprüche entspricht.

15. Vorrichtung (1), umfassend das schwingungsfähige mechanische System nach Anspruch 14 und eine selbstregulierende Schaltung (10) zum Steuern der Schwingungsfrequenz des schwingungsfähigen mechanischen Systems, wobei der Schaltkreis zur Selbstregulierung (10) eine Oszillatorstufe (55) zum Bereitstellen eines Referenzsignals (V_{R}), Mittel (52, 53, 54, 57) zum Vergleichen der Frequenz zwischen zwei Signalen, und eine Frequenzanpassungseinheit (58), die mit dem piezoelektrischen Element (3) des schwingungsfähigen mechanischen Systems verbunden ist und ein Frequenzanpassungssignal (V_{A}) bereitstellt, umfasst, **dadurch gekennzeichnet, dass** das piezoelektrische Element (3) des schwingungsfähigen mechanischen Systems eine Wechselspannung (V_{P}) mit einer Frequenz erzeugen kann, die dem schwingungsfähigen mechanischen System entspricht, wobei die erste und zweite Elektrode (8a, 8b) des piezoelektrischen Elements mit dem Schaltkreis zur Selbstregulierung (10) verbunden sind, um das Frequenzanpassungssignal (V_{A}) von der Frequenzanpassungseinheit (58) zu empfangen, aufgrund des Ergebnisses eines Frequenzvergleichs, mithilfe der Frequenzvergleichsmittel, zwischen der Wechselspannung (V_{P}) und der Referenzspannung (V_{R}).

16. Vorrichtung (1) nach Anspruch 15, **dadurch gekennzeichnet, dass** die selbstregulierende Schaltung (10) zur Steuerung der Schwingungsfrequenz des schwingungsfähigen mechanischen Systems ferner einen Gleichrichter (51) umfasst, um die von dem piezoelektrischen Element (3) erzeugte Wechselspannung (V_{P}) gleichzurichten und die gleichgerichtete Spannung auf mindestens einem Kondensator (Cc) zu speichern, um den Schaltkreis zur Selbstregulierung mit elektrischem Strom zu versorgen.

17. Vorrichtung (1) nach Anspruch 15 oder 16, **dadurch gekennzeichnet, dass** die Oszillatorstufe (55) des Schaltkreises zur Selbstregulierung (10) eine Oszillatorschaltung umfasst, die mit einem MEMS-Resonator (56) verbunden ist, um ein schwingungsfähiges Signal bereitzustellen, sodass die Oszillatorstufe (55) das Referenzsignal (V_{R}) bereitstellt, wobei alle elektronischen Komponenten des Schaltkreises zur Selbstregulierung zusammengruppiert sind, um ein einzelnes elektronisches Modul zu bilden.

## Claims

1. A piezoelectric element (3) for a self-regulating frequency control circuit (10), the piezoelectric element (3) comprising:
- a balance spring (7) formed of a strip of piezoelectric material;
- a first electrode (8a), to be connected to the self-regulating frequency control circuit (10), and fitted on at least a first side of the strip of piezoelectric material;
- a second electrode (8b), to be connected to the self-regulating frequency control circuit (10), and fitted on at least a second side of the strip of piezoelectric material;
**characterised in that** the piezoelectric material is a piezoelectric crystal or a piezoelectric ceramic; and
**in that** the first and second electrodes (8a, 8b) are fitted on a portion of an outer coil of the balance spring (7), said portion comprising one end of the balance spring and defining a predetermined angular sector.

2. A piezoelectric element (3) for a self-regulating frequency control circuit (10), the piezoelectric element (3) comprising:
- a balance spring (7) formed of a strip of piezoelectric material;
- a first electrode (8a), to be connected to the self-regulating frequency control circuit (10), and fitted on at least a first side of the strip of piezoelectric material;
- a second electrode (8b), to be connected to the self-regulating frequency control circuit (10), and fitted on at least a second side of the strip of piezoelectric material;
**characterised in that** the piezoelectric material is a piezoelectric crystal or a piezoelectric ceramic,
**in that** the first electrode (8a) comprises first parts fitted on the first side of the strip of piezoelectric material, and second parts fitted on at least one side of the strip of piezoelectric material different to the first side,
**in that** the second electrode (8b) comprises first parts fitted on the second side of the strip of piezoelectric material, and second parts fitted on at least one side of the strip of piezoelectric material different to the second side,
**in that** the first and second parts of the first electrode (8a) and of the second electrode (8b), respectively, are alternately connected to each other in junction zones, and
**in that** the junction zones are distributed over the balance spring (7) at a predetermined angular frequency.

3. The piezoelectric element (3) according to claim 1, **characterised in that** the first and second electrodes (8a, 8b) are fitted on one portion (12) of an outer coil (14) of the balance spring (7), said portion (12) comprising one end (7a) of the balance spring (7) and defining a predetermined angular sector.

4. The piezoelectric element (3) according to claim 1, **characterised in that** the first electrode (8a) comprises first parts (18a; 30a) fitted on the first side of the strip of piezoelectric material and second parts (18b; 30b) fitted on at least one side of the strip of piezoelectric material different to the first side; **in that** the second electrode (8b) comprises first parts (20a; 32a) fitted on the second side of the strip of piezoelectric material and second parts (20b; 32b) fitted on at least one side of the strip of piezoelectric material different to the second side; the first and second parts of the first electrode (8a) respectively the second electrode (8b) being alternately connected to each other in junction zones (22, 24; 38, 40); and **in that** said junction zones (22, 24; 38, 40) are distributed over the balance spring (7) with a predetermined angular periodicity.

5. The piezoelectric element (3) according to claim 4, **characterised in that** the second parts (18b) of the first electrode (8a) and the second parts (20b) of the second electrode (8b) are fitted on a third side of the strip of piezoelectric material; and **in that** said second parts (18b, 20b) of the first and second electrodes (8a, 8b) extend in succession and alternately one after the other on the third side of the strip of piezoelectric material with said predetermined angular periodicity.

6. The piezoelectric element according to claim 4, **characterised in that** it comprises a third electrode (8c) and a fourth electrode (8d); the third electrode (8c) being connected to the first electrode (8a) at a first connection terminal (26) to be connected to the self-regulating frequency control circuit (10), the third electrode (8c) comprising first parts (34a) fitted on a third side of the strip of piezoelectric material and second parts fitted on at least one side of the strip of piezoelectric material different to the third side; the fourth electrode (8d) being connected to the second electrode (8b) at a second connection terminal (28) to be connected to the self-regulating frequency control circuit (10), the fourth electrode (8d) comprising first parts (36a) fitted on a fourth side of the strip of piezoelectric material and second parts fitted on at least one side of the strip of piezoelectric material different to the fourth side; the first and second parts of the third electrode (8c) respectively the fourth electrode (8d) being alternately connected to each other in junction zones (42, 44); and **in that** said junction zones (42, 44) are distributed over the balance spring (7) with said predetermined angular periodicity.

7. The piezoelectric element (3) according to claim 6, **characterised in that** each second part of the first, second, third, respectively fourth electrode extends over each side of the strip of piezoelectric material different to the first, second, third, respectively fourth side; and **in that** the first, second, third and fourth electrodes (8a-8d) extend in succession and alternately one after the other on each side of the strip of piezoelectric material, with a predetermined angular sub-periodicity.

8. The piezoelectric element (3) according to claims 5 to 7, **characterised in that** the electrodes are fitted over the entire length of the balance spring.

9. The piezoelectric element (3) according to claim 1, **characterised in that** the piezoelectric crystal is a single crystal chosen from the group consisting of topaz, berlinite, lithium niobate, lithium tantalate, gallium phosphate, gallium arsenate, aluminium silicate, germanium dioxide, a single crystal tourmaline, a single crystal from the group of zinc-blende-structure III-V semiconductors, or a single crystal from the group of wurtzite structure II-VI semiconductors.

10. The piezoelectric element (3) according to claim 1, **characterised in that** the piezoelectric crystal is single crystal quartz.

11. The piezoelectric element (3) according to claim 10, **characterised in that** the balance spring (7) is machined in Z -cut single crystal quartz.

12. The piezoelectric element (3) according to claim 9 or 10 when it depends from claim 2 or 3, **characterised in that** the predetermined angular sector, the predetermined angular periodicity or the predetermined angular sub-periodicity is substantially equal to 60°.

13. The piezoelectric element (3) according to any of the preceding claims, **characterised in that** it further comprises at least one groove (16a) cut into the first upper or lower side of the strip of piezoelectric material, said first electrode (8a) being at least partially fitted in said groove (16a), said second electrode (8b) being at least partially fitted on a second outer or inner side.

14. An oscillating mechanical system for a self-regulating frequency control circuit (10), comprising a balance (2) and a piezoelectric element (3) provided with a balance spring (7), the balance spring (7) being mounted on said balance (2), **characterised in that** the piezoelectric element (3) conforms to any of the preceding claims.

15. A device (1) comprising the oscillating mechanical system according to claim 14 and a self-regulating circuit (10) for controlling the oscillation frequency of the oscillating mechanical system, said self-regulating control circuit (10) comprising an oscillator stage (55) for providing a reference signal (V_{R}), means (52, 53, 54, 57) for comparing the frequency between two signals, and a frequency adaptation unit (58) connected to the piezoelectric element (3) of the oscillating mechanical system and providing a frequency adaptation signal (V_{A}), **characterised in that** the piezoelectric element (3) of the oscillating mechanical system can generate an alternating voltage (V_{P}) at a frequency corresponding to the oscillating mechanical system, the first and second electrodes (8a, 8b) of the piezoelectric element being connected to the self-regulating control circuit (10) in order to receive the frequency adaptation signal (V_{A}) from the frequency adaptation unit (58), on the basis of the result of a frequency comparison, in the frequency comparison means, between the alternating voltage (V_{P}) and the reference voltage (V_{R})

16. The device (1) according to claim 15, **characterised in that** the self-regulating circuit (10) for controlling the oscillation frequency of the oscillating mechanical system further comprises a rectifier (51) for rectifying the alternating voltage (V_{P}) generated by the piezoelectric element (3) and for storing the rectified voltage on at least one capacitor (Cc), in order to supply the self-regulating control circuit with electricity.

17. The device (1) according to claim 15 or 16, **characterised in that** the oscillator stage (55) of the self-regulating control circuit (10) comprises an oscillating circuit connected to a MEMS resonator (56) to provide an oscillating signal, so that the oscillator stage (55) provides the reference signal (V_{R}), all the electronic components of the self-regulating control circuit being grouped together to form a single electronic module.
